# EUROPEAN PATENT APPLICATION

(11) **EP 4 622 136 A1**
(43) Date of publication of application: **24.09.2025**
(21) Application number: 25164392.0
(22) Date of filing: 18.03.2025
(51) Int. Cl.: H04B 10/40, H04L 7/033

(54) **FAST DIGITAL LANE DROP DETECTION SYSTEM FOR MULTI-LANE DIRECT DETECT TRANSCEIVERS**

(30) Priority: 18.03.2024 US 202463566773 P; 17.03.2025 US 202519082066
(71) Applicant: Cisco Technology, Inc., San Jose, CA 95134 (US)
(72) Inventor: NANDWANA, Romesh Kumar, Carlsbad (US); BHAT, Abhishek, Allentown (US); TIAO, Jenjen, Allentown (US); ARRA, Sai Suhas, Allentown (US); SUNDER, Sanjay, Allentown (US)
(74) Representative: Thomas, Tomos Daniel

(57) **Abstract**

Lane drop detection techniques for multi-lane optical transceivers are provided. In one aspect, a method includes capturing a phase interpolator (PI) control word for each lane of an optical transceiver; determining a lane difference between a master lane and each non-master lane; calculating a difference associated with each non-master lane, wherein the difference associated with a given non-master lane is calculated as a difference between the lane difference associated with the given non-master lane and a reference lane difference associated with the given non-master lane; upon determining that at least one of the differences has reached a drift threshold, determining that the master lane or one or more of the non-master lanes is invalid based on which of the differences have reached the drift threshold; and performing a control action when the master lane or one or more of the non-master lanes is invalid.

## Description

### CROSS-REFERENCE TO RELATED APPLICATIONS

This application claims benefit of co-pending United States provisional patent application Serial No. 63/566,773 filed March 18, 2024. The aforementioned related patent application is herein incorporated by reference in its entirety.

### TECHNICAL FIELD

Embodiments presented in this disclosure generally relate to land drop detection techniques for multi-lane optical transceivers.

### BACKGROUND

The data rate demand in data-centers has been increasing, which has in turn increased the popularity of multi-lane optical transceiver-based optical modules. These modules can provide high data rates in small form factors with as high as 8/16 lane transceivers with a single digital signal processing (DSP) chip (e.g., 800G, 1.6T module based on 100G/λ & 200G/λ). Ideally, these multi-lane optical transceivers should be able to operate as an Nx100G transceiver, where N is between 1 and 8, change its configuration on the fly without affecting the active channels, and the active channels' parts per million (PPM) frequency information should be successfully transferred to the output without or with negligible errors.

However, these multi-channel transceivers have stringent power dissipation requirements to fit in the small form-factors such as Octal Small Form Factor Pluggable-double density (OSFP-DD) and Quad Small Form Factor Pluggable-double density (QSFP-DD). Typically, this requirement of frequency information transfer is achieved using per lane phase interpolators (PI), or per lane phase-locked loops (PLLs) for each transmitter and receiver block, consuming a significant amount of area and power.

### BRIEF DESCRIPTION OF THE DRAWINGS

So that the manner in which the above-recited features of the present disclosure can be understood in detail, a more particular description of the disclosure, briefly summarized above, may be had by reference to embodiments, some of which are illustrated in the appended drawings. It is to be noted, however, that the appended drawings illustrate typical embodiments and are therefore not to be considered limiting; other equally effective embodiments are contemplated.
FIG. 1A is a schematic diagram of an optical module according to one or more aspects of the present disclosure.
FIG. 1B is a schematic block diagram of features of the multi-lane optical transceiver of the optical module of FIG. 1A.
FIG. 2 is a flow diagram for a method of fast digital lane drop detection for a multi-lane direct detect optical transceiver, according to one or more aspects of the present disclosure.
FIG. 3 depicts control logic for constructing a reference table, in accordance with the method of FIG. 2.
FIG. 4 depicts a constructed reference table, in accordance with the method of FIG. 2.
FIG. 5 depicts control logic for constructing a lane difference table, in accordance with the method of FIG. 2.
FIG. 6 depicts a constructed lane difference table, in accordance with the method of FIG. 2.
FIG. 7 depicts a constructed difference table, in accordance with the method of FIG. 2.
FIG. 8 depicts control logic for determining whether a master lane is valid, in accordance with the method of FIG. 2.
FIG. 9 depicts control logic for constructing a new reference table, in accordance with a subsequent iteration of the method of FIG. 2.
FIG. 10 depicts control logic for constructing a new lane difference table, in accordance with a subsequent iteration of the method of FIG. 2.
FIG. 11 is a block diagram of a computing system according to one or more aspects of the present disclosure.

To facilitate understanding, identical reference numerals have been used, where possible, to designate identical elements that are common to the figures. It is contemplated that elements disclosed in one embodiment may be beneficially used in other embodiments without specific recitation.

### DESCRIPTION OF EXAMPLE EMBODIMENTS

### OVERVIEW

In one aspect, a method is provided. The method includes capturing a phase interpolator (PI) control word for each lane of a plurality of lanes of an optical transceiver, wherein one lane of the plurality of lanes is assigned as a master lane and other ones of the plurality of lanes that are not the master lane are designated as non-master lanes; determining a lane difference between the master lane and each of the non-master lanes, with the lane difference being determined between the master lane and a given one of the non-master lanes as a difference between the PI control word associated with the master lane and the PI control word associated with the given one of the non-master lanes; calculating a difference associated with each one of the non-master lanes by determining a difference between the lane difference associated with a given one of the non-master lanes and a reference lane difference associated with the given one of the non-master lanes; upon determining that at least one of the differences has reached a drift threshold, determining that the master lane or one or more of the non-master lanes is invalid based on which of the differences have reached the drift threshold; and performing a control action when the master lane or one or more of the non-master lanes is invalid.

In another aspect, an optical transceiver is provided. The optical transceiver includes a plurality of receivers each having a clock and data recovery (CDR) circuit; a plurality of optical drivers electrically coupled with the receivers via respective ones of a plurality of lanes; and a processor arranged to execute a program to perform operations. The operations include: capturing, from the CDR circuits, a phase interpolator (PI) control word for each lane of a plurality of lanes, wherein one lane of the plurality of lanes is assigned as a master lane and other ones of the plurality of lanes that are not the master lane are designated as non-master lanes; determining a lane difference between the master lane and each of the non-master lanes, with the lane difference being determined between the master lane and a given one of the non-master lanes as a difference between the PI control word associated with the master lane and the PI control word associated with the given one of the non-master lanes; calculating a difference associated with each one of the non-master lanes by determining a difference between the lane difference associated with a given one of the non-master lanes and a reference lane difference associated with the given one of the non-master lanes; upon determining that at least one of the differences has reached a drift threshold, determining that the master lane or one or more of the non-master lanes is invalid based on which of the differences have reached the drift threshold; and performing a control action when the master lane or one or more of the non-master lanes is invalid.

In yet another aspect, an optical module is provided. The optical module includes an application-specific integrated circuit (ASIC); an optical transceiver electrically coupled with the ASIC by a plurality of lanes, and wherein the optical transceiver has a transmitter phase-locked loop (PLL) arranged to receive a phase interpolator (PI) control word from a master lane of the plurality of lanes; and a processor arranged to execute a program to perform operations. The operations include: capturing a PI control word for each lane of the plurality of lanes, wherein one lane of the plurality of lanes is assigned as the master lane and other ones of the plurality of lanes that are not the master lane are designated as non-master lanes; determining a lane difference between the master lane and each of the non-master lanes, with the lane difference being determined between the master lane and a given one of the non-master lanes as a difference between the PI control word associated with the master lane and the PI control word associated with the given one of the non-master lanes; calculating a difference associated with each one of the non-master lanes by determining a difference between the lane difference associated with a given one of the non-master lanes and a reference lane difference associated with the given one of the non-master lanes; upon determining that each one the differences has reached a drift threshold, determining that the master lane is invalid when each one of the differences have reached the drift threshold; and switching the master lane from the one lane to another lane of the plurality of lanes so that the transmitter PLL receives the PI control word from the other lane that is now the master lane.

### EXAMPLE EMBODIMENTS

The present disclosure provides techniques for fast digital lane drop detection for multi-lane optical transceivers. The detection techniques disclosed herein can enable monitoring of a plurality of lanes in a transmitter path of a multi-lane optical transceiver, including monitoring of the validity of a master lane and non-master lanes, as well as dynamic switching of the master lane to another lane when the master lane drops or otherwise becomes invalid.

In at least one example, phase interpolator (PI) control words can be captured for each lane of a multi-lane optical transceiver. Lane differences between the PI control word for the master lane and the PI control word for each of the non-master lanes can be determined. Further, differences (or error values) between the determined lane differences and reference lane differences can be calculated. The reference lane differences can be captured during a reference capture period, such as during initialization or after a lane status of one of the lanes has changed. During the reference capture period, PI control words for each lane can be captured and the reference lane differences can be determined as differences between the PI control word associated with the master lane and the PI control word associated with a given one of the non-master lanes. The differences (or error values) between the determined lane differences and reference lane differences can be compared to a drift threshold. When all of the calculated differences have reached the threshold, the master lane can be detected as invalid. Accordingly, the master lane can be switched to another valid lane, such as to a valid neighbor lane. When one or some, but not all, of the calculated differences have reached the threshold, the non-master lanes associated with these calculated differences can be detected as invalid, e.g., and removed from further consideration for one or more subsequent iterations. Accordingly, the lane drop detection method disclosed herein can be considered a "difference-of-the-difference" technique. Lane differences can be determined, and then these determined lane differences and reference lane differences can be used to determine differences (error values), which can be compared against the drift threshold to ultimately determine if the master lane or other ones of the lanes are invalid. Control actions can be performed when one or more of the lanes are found to be invalid.

The disclosed detection techniques can provide one or more advantages, benefits, and/or technical effects. For instance, the disclosed techniques can enable the use of a single PLL/PPM master architecture for dynamic lane switching on the fly without disturbing the traffic on the active channels. The detection system can reduce the number of phase interpolator (Pls), or phase rotators, in the transmitter path of a multi-lane optical transmitter, e.g., by one fourth or one eighth, while allowing seamless lane-switching. The detection system and techniques disclosed herein can utilize PI code words and a "difference-of-the-difference" technique, as noted above, to detect lane drops and allow for seamless switching of the PPM information from different receivers along the transmitter path. In this regard, the detection techniques and systems disclosed herein can provide a technological solution for improving the performance and functionality of multi-lane optical transceivers.

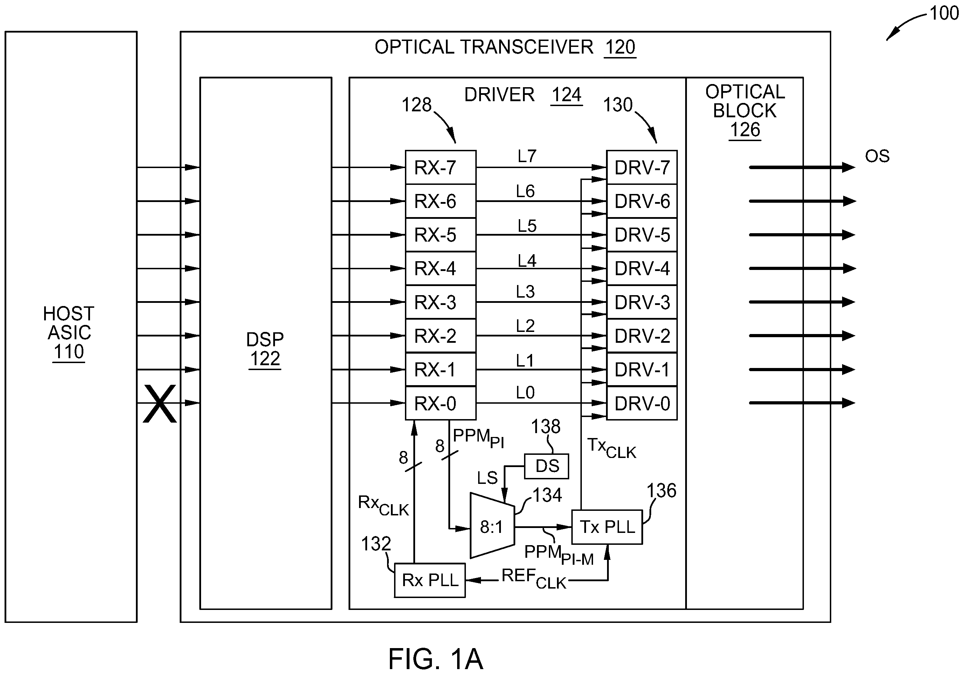

Turning now to the drawings, FIG. 1A is a schematic diagram of a transmitter path of an optical module 100. The optical module 100 includes a host application-specific integrated circuit (ASIC), or host ASIC 110, along with a multi-lane optical transceiver 120. The host ASIC 110 is electrically coupled with the multi-lane optical transceiver 120 by a plurality of lanes. In the depicted example of FIG. 1A, the optical module 100 includes eight (8) lanes on its transmitter path, including a zeroth lane L0, a first lane L1, a second lane L2, a third lane L3, a fourth lane L4, a fifth lane L5, a sixth lane L6, and a seventh lane L7. In other examples, the optical module 100 can include a different number of lanes. In one or more examples, one of the lanes can be assigned as the master lane. For instance, in FIG. 1A, the zeroth lane L0 can be assigned as the master lane.

The multi-lane optical transceiver 120 includes a digital signal processor (DSP), or DSP 122, a driver 124, and an optical block 126. The DSP 122 can convert analog electrical signals received from the host ASIC 110 into digital data. This digital data can be routed to the driver 124. The driver 124 includes a plurality of receivers 128. In at least one example, the receivers 128 can be extremely short-reach receivers (XSRs). The driver 124 also includes a plurality of optical drivers 130 electrically coupled with respective ones of the receivers 128, e.g., by way of the lanes. In the illustrated example of FIG. 1A, the driver 124 includes eight (8) receivers (one per lane), including RX-0 through RX-7, as well as eight (8) optical drivers (one per lane), including DRV-0 through DRV-7.

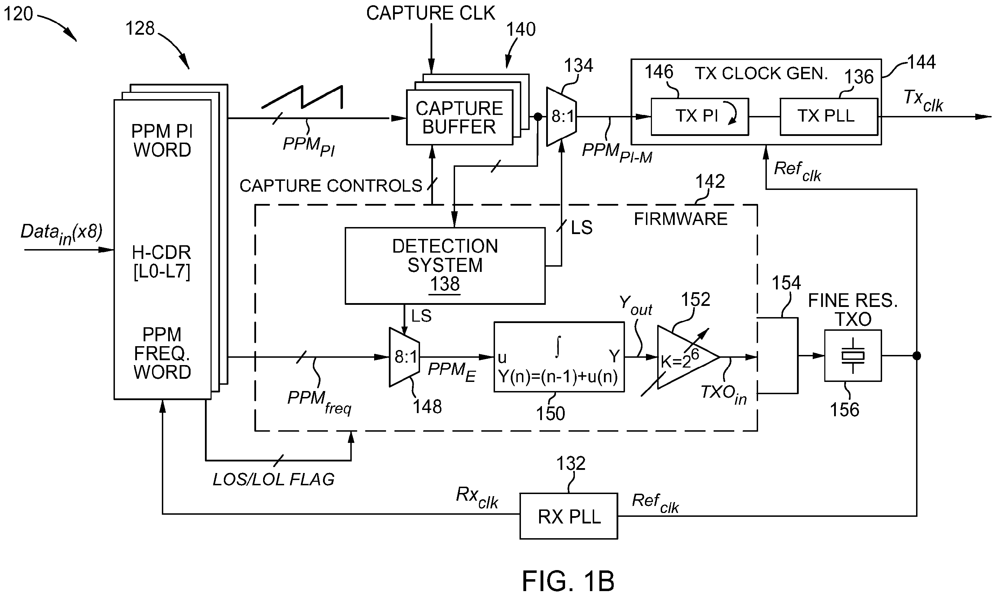

A receiver phase-locked loop (PLL), or receiver PLL 132, can input a receiver clock signal Rx_{CLK} to respective ones of the receivers 128. The receiver clock signal Rx_{CLK} can be based at least in part on a reference clock signal Ref_{CLK} (see also FIG. 1B). Moreover, each one of the receivers 128 can include a clock and data recovery (CDR) circuit, such as high-speed clock and data recovery (H-CDR) circuits. The H-CDR circuits of a given one of the receivers 128 can be arranged to capture phase and frequency information (or parts-per-million (PPM) information) of data signals traveling along its associated lane. The phase information, or phase interpolator (PI) control word PPM_{PI}, from each lane can be input into a multiplexer 134. The multiplexer 134 can output a master lane PI control word PPM_{PI-M} (i.e., the PI control word associated with the master lane) to a transmitter PLL 136. In FIG. 1A, the zeroth lane L0 is assigned as the master lane, and thus, the master lane PI control word PPM_{PI-M} output by the multiplexer 134 is the PI control word captured from the zeroth lane L0. The transmitter PLL 136 can output a transmitter clock signal Tx_{CLK} to respective ones of the optical drivers 130 based on the master lane PI control word PPM_{PI-M} and the reference clock signal Ref_{CLK}.

The optical drivers 130 can each provide outputs to the optical block 126, or more specifically, to respective light emitters. The light emitters can transmit optically modulated signals OS based on the outputs received from the optical drivers 130. The optical signals OS can be carried along respective optical fibers, for example. The light emitters can be modulated lasers or Mach-zehnder interferometers, for example.

In one or more examples, one or more of the lanes can drop or otherwise become invalid, including the master lane. For instance, when the master lane drops or becomes invalid, as designated by the "X" along the zeroth lane L0 in FIG. 1A, the multi-lane optical transceiver 120 may not operate optimally and/or a first-in, first-out (FIFO) memory device associated with the multi-lane optical transceiver 120 can crash or otherwise operate less than optimally. In accordance with the inventive aspects of the present disclosure, the multi-lane optical transceiver 120 can include a fast digital lane drop detection system, or detection system 138, arranged to detect lane drops and to switch the master lane to another valid lane when the master lane drops. When the master lane has dropped, the detection system 138 can be used to control switching of the master lane to another one of the lanes, such as to a neighbor lane. A lane switch input LS indicating that the master lane has been switched to a new master lane can be provided to the multiplexer 134 as depicted in FIG. 1A and used to control the PI control word output by the multiplexer 134 to the transmitter PLL 136. That is, when the master lane is switched from one lane to another, rendering a new master lane, the PI control word associated with the new master lane is output by the multiplexer 134 to the transmitter PLL 136. In this way, the detection system 138 can detect lane drops immediately and switch the master lane with no FIFO crash and/or no or reduced forward error correction (FEC) alignment loss.

FIG. 1B is a schematic block diagram of features of the multi-lane optical transceiver 120. As depicted, the phase information of the PPM frequency error (or PI control words PPM_{PI}) from the H-CDR circuits of the receivers 128 can be captured using a capture buffer 140. The PI control words PPM_{PI} can be passed to the detection system 138, which can be an executable program of firmware 142 of the multi-lane optical transceiver 120. In one or more other examples, the detection system 138 can be an executable software program stored on a memory device, such as a non-transitory memory device. As noted above, the detection system 138 is arranged to detect lane drops and switching of the master lane to another valid lane when the master lane has dropped. The lane switch input LS indicating that the master lane has been switched to a new master lane can be provided to the multiplexer 134 as depicted in FIG. 1B. The master lane PI control word PPM_{PI-M} can be provided to a transmitter clock generator 144. The transmitter clock generator 144 includes a transmitter PI 146 and the transmitter PLL 136. The transmitter clock generator 144 can generate the transmitter clock signal Tx_{CLK}, e.g., which can be routed to respective ones of the optical drivers 130 as shown in FIG. 1A.

In addition, frequency control words PPM_{freq} captured by the H-CDR circuits of the receivers 128 can be input into the firmware 142. The frequency control words PPM_{freq} from each lane can be input into a firmware multiplexer 148. The firmware multiplexer 148 can output a frequency error PPM_{E}, which can correspond to the frequency control word associated with the master lane. The frequency error PPM_{E} can be input into an accumulator 150, which can accumulate the frequency error PPM_{E}. A gain 152 can be applied to an output Yₒᵤₜ of the accumulator 150, rendering an oscillator input TXOᵢₙ. The oscillator input TXOᵢₙ can be output from the firmware 142 by an inter-integrated circuit 154, which can route the oscillator input TXOᵢₙ to a tunable crystal oscillator 156. The tunable oscillator 156 can output the reference clock signal Ref_{CLK} to the transmitter clock generator 144 and the receiver PLL 132. The transmitter PLL 136 of the transmitter clock generator 144 can use the reference clock signal Ref_{CLK} to generate the transmitter clock signal Tx_{CLK}, which can be routed to respective ones of the optical drivers 130 as shown in FIG. 1A. The receiver PLL 132 can use the reference clock signal Ref_{CLK} to generate the receiver clock signal Rx_{CLK}, which can be fed to the receivers 128 as shown in FIG. 1B. Also, a loss of signal (LOS) or loss of CDR lock flag (LOL) captured by the H-CDR circuits of the receivers 128 can be input into the firmware 142.

Accordingly, when executed by one or more processors, the firmware 142 accumulates the frequency error and drives the tunable oscillator 156 (e.g., via a serial peripheral interface (SPI)), whose output is fed as a reference clock to the transmitter PLL 136 and the receiver PLL 132. The feedback loop sets the control word of the tunable oscillator 156 such that the average frequency error between the Tx/Rx PLL clocks and the incoming data (Dataᵢₙ) received by the receivers 128 is near-zero. Indeed, the host ASIC 110, the DSP 122, and the driver 124 (see FIG. 1A) can all have their own oscillator sources, and consequently, there may be frequency error between them. Nevertheless, the control scheme set forth in FIG. 1B can ensure that the average frequency error between the Tx/Rx PLL clocks and the incoming data (Dataᵢₙ) received by the receivers 128 is near-zero, e.g., <<0.1PPM, as noted above.

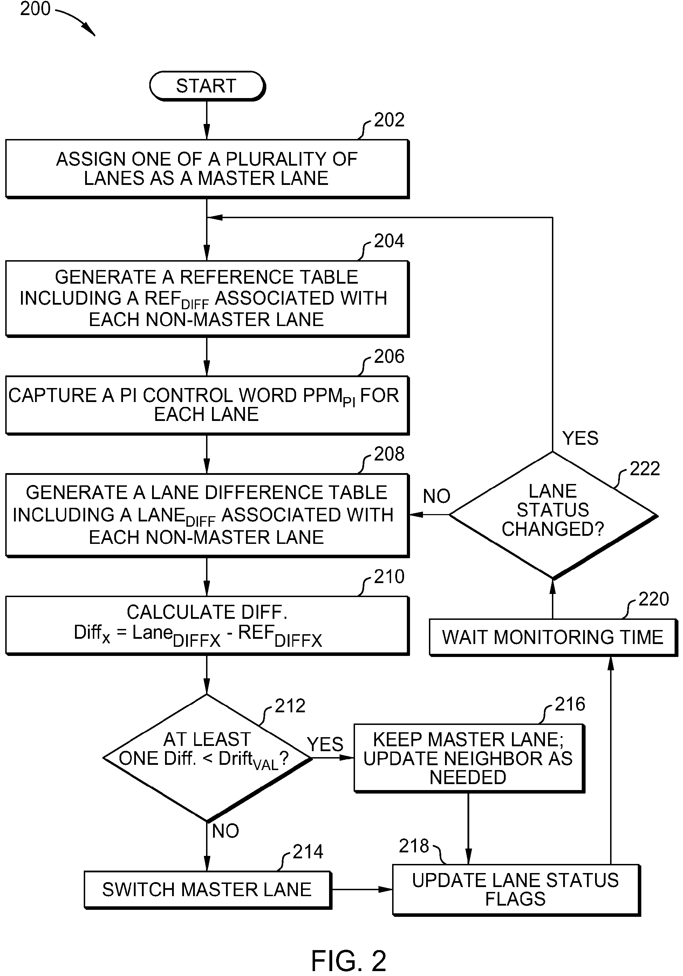

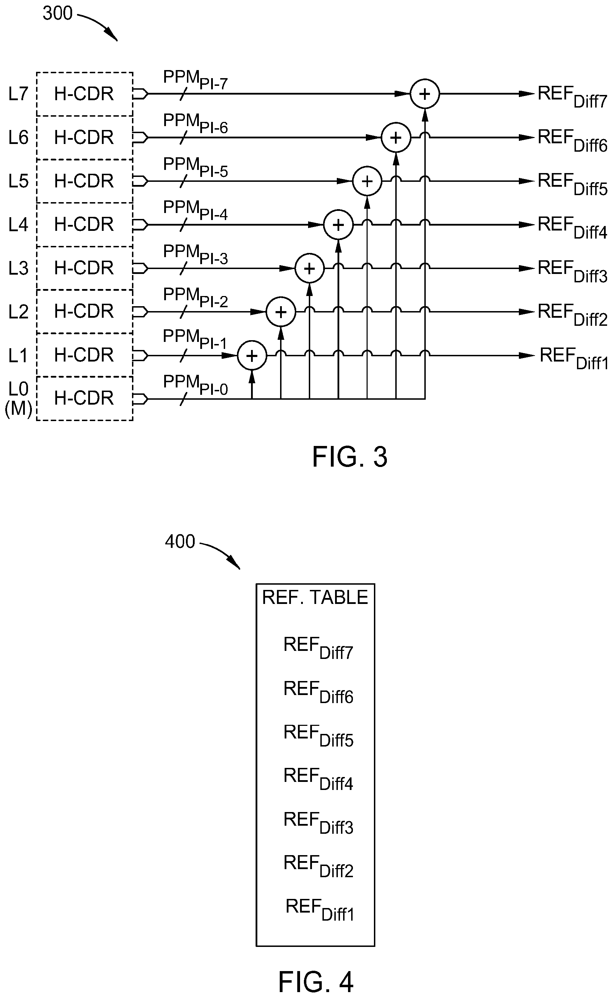

FIG. 2 is a flow diagram for a method 200 of fast digital lane drop detection for a multi-lane direct detect optical transceiver, according to one or more aspects of the present disclosure. The method 200 can be used to implement aspects of the detection system 138 for the multi-lane optical transceiver 120 of FIGS. 1A and 1B, for example. Accordingly, to provide additional context to the method 200, elements of FIGS. 1A and 1B will be referenced below. Also, FIGS. 3 through 10 will also be referenced to provide additional context to the method 200 of FIG. 2.

At 202, the method 200 can include assigning one lane of a plurality of lanes of an optical transceiver as a master lane. Other ones of the plurality of lanes that are not the master lane can be designated as non-master lanes. For instance, in one example and with reference to FIGS. 1A and 1B, the master lane can be assigned to the zeroth lane L0. Consequently, the first through seventh lanes, or L1 through L7, can be designated as the non-master lanes. In one or more examples, in addition to assigning one of the lanes as the master lane, the method 200 can include assigning one of the non-master lanes as a neighbor lane. In at least one example, the neighbor lane can be designated as the next master lane. The neighbor lane can be a closest physical neighbor to the master lane, (e.g., the first lane L1 with respect to the zeroth lane L0) or can be selected according to some other criteria, such as the lane with the next lowest phase difference. For instance, with the zeroth lane L0 being assigned as the master lane, the fifth lane L5 can be selected as the neighbor lane, e.g., according to a predefined condition or criteria.

At 204, the method 200 can include generating a reference table. The reference table can be generated at initialization of the method 200 and also at subsequent iterations of the method 200, such as after a lane status change of one or more of the lanes, e.g., as determined at 222, including after the master lane has been switched to another lane.

In at least one implementation, with reference to FIGS. 3 and 4, the reference table can be generated by capturing a PI control word PPM_{PI} of each lane of the plurality of lanes. For instance, the PI control words PPM_{PI} from the H-CDR circuits of the receivers 128 can be captured for each lane using the capture buffer 140 (FIG. 1B). Capture controls set in the firmware 142 can be provided to the capture buffer 140, e.g., to control capture of the PI control words PPM_{PI}. As provided in FIG. 3, a zeroth PI control word PPM_{PI-0} can be captured for the zeroth lane L0 (also the master lane control word PPM_{PI-M} in this example where the master lane is assigned to the zeroth lane L0), a first PI control word PPM_{PI-1} can be captured for the first lane L1, a second PI control word PPM_{PI-2} can be captured for the second lane L2, a third PI control word PPM_{PI-3} can be captured for the third lane L3, a fourth PI control word PPM_{PI-4} can be captured for the fourth lane L4, a fifth PI control word PPM_{PI-5} can be captured for the fifth lane L5, a sixth PI control word PPM_{PI-6} can be captured for the sixth lane L6, and a seventh PI control word PPM_{PI-7} can be captured for the seventh lane L7.

The reference table can be further generated by determining a reference lane difference REF_{DIFF} associated with each one of the non-master lanes. The reference lane difference REF_{DIFF} can be determined for a given one of the non-master lanes as a difference between the PI control word PPM_{PI-M} associated with the master lane and the PI control word PPM_{PI} associated with the given one of the non-master lanes.

For instance, as depicted in control logic 300 of FIG. 3, with the master lane assigned to the zeroth lane L0 in this example, a first reference lane difference REF_{DIFF1} can be determined as a difference between the PI control word PPM_{PI-M} associated with the master lane and the PI control word PPM_{PI-1} associated with the first lane L1. Further, a second reference lane difference REF_{DIFF2} can be determined as a difference between the PI control word PPM_{PI-M} associated with the master lane and the PI control word PPM_{PI-2} associated with the second lane L2, a third reference lane difference REF_{DIFF3} can be determined as a difference between the PI control word PPM_{PI-M} associated with the master lane and the PI control word PPM_{PI-3} associated with the third lane L3, a fourth reference lane difference REF_{DIFF4} can be determined as a difference between the PI control word PPM_{PI-M} associated with the master lane and the PI control word PPM_{PI-4} associated with the fourth lane L4, a fifth reference lane difference REF_{DIFF5} can be determined as a difference between the PI control word PPM_{PI-M} associated with the master lane and the PI control word PPM_{PI-5} associated with the fifth lane L5, a sixth reference lane difference REF_{DIFF6} can be determined as a difference between the PI control word PPM_{PI-M} associated with the master lane and the PI control word PPM_{PI-6} associated with the sixth lane L6, and a seventh reference lane difference REF_{DIFF7} can be determined as a difference between the PI control word PPM_{PI-M} associated with the master lane and the PI control word PPM_{PI-7} associated with the seventh lane L7.

The reference table can be further generated by constructing the reference table to include the reference lane differences, including REF_{DIFF1} through REF_{DIFF7}. FIG. 4 shows a reference table 400 constructed with REF_{DIFF1} through REF_{DIFF7}. In one or more examples, the reference table 400 is created only when there is a change in the valid lane status. For example, this lane status flag can be obtained from LOS/LOL flags or if a drift is detected and a lane becomes invalid.

At 206, the method 200 can include capturing a PI control word PPM_{PI} for each lane of the plurality of lanes. For instance, after the reference table is constructed at 204, lane drop detection can commence by capturing the PI control word for each lane. In at least one example, a predetermined period of time can pass between after executing 204 and before executing 206. The PI control words PPM_{PI} from the H-CDR circuits of the receivers 128 can be captured for each lane using the capture buffer 140.

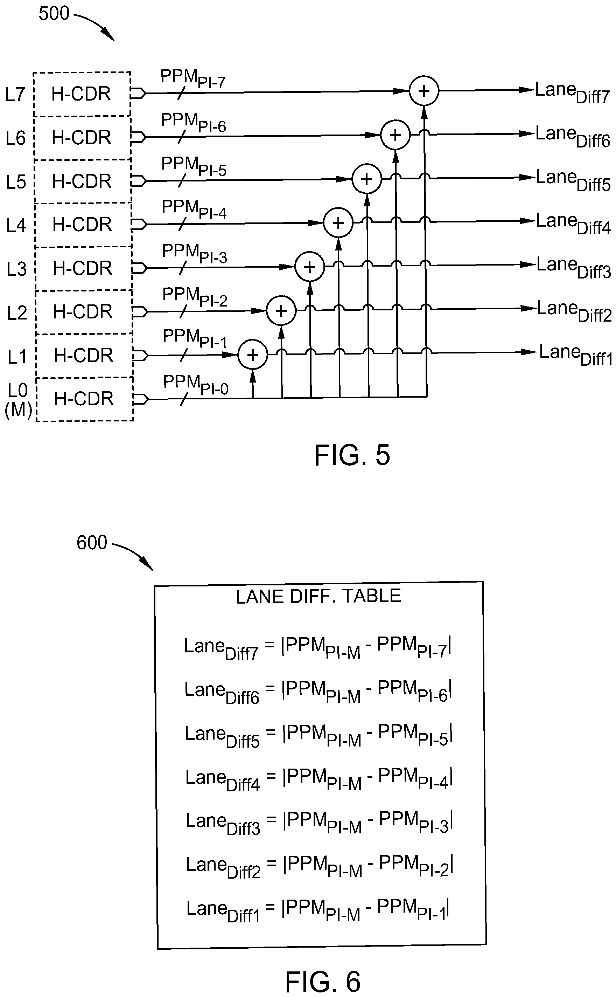

The PI control word PPM_{PI} for each lane of the plurality of lanes can be captured in accordance with the control logic 500 depicted in FIG. 5. As shown, a zeroth PI control word PPM_{PI-0} can be captured for the zeroth lane L0 (also the master lane control word PPM_{PI-M} in this example where the master lane is assigned to the zeroth lane L0). Further, a first PI control word PPM_{PI-1} can be captured for the first lane L1, a second PI control word PPM_{PI-2} can be captured for the second lane L2, a third PI control word PPM_{PI-3} can be captured for the third lane L3, a fourth PI control word PPM_{PI-4} can be captured for the fourth lane L4, a fifth PI control word PPM_{PI-5} can be captured for the fifth lane L5, a sixth PI control word PPM_{PI-6} can be captured for the sixth lane L6, and a seventh PI control word PPM_{PI-7} can be captured for the seventh lane L7.

At 208, the method 200 can include generating a lane difference table that include a lane difference Lane_{DiffX} associated with each one of the non-master lanes. The lane difference table can be generated by determining a lane difference Lane_{DiffX} between the master lane and respective ones of the non-master lanes, with the lane difference Lane_{DiffX} being determined between the master lane and a given one of the non-master lanes as a difference between the PI control word PPM_{PI-M} associated with the master lane and the PI control word PPM_{PI} associated with the given one of the non-master lanes. FIG. 6 shows a lane difference table 600.

For instance, with reference to FIG. 6, a first lane difference Lane_{Diff1} can be determined between the master lane (the zeroth lane L0 in this example) and the first lane L1 as a difference between the PI control word PPM_{PI-M} associated with the master lane and the PI control word PPM_{PI-1} associated with the first lane L1. Also, a second lane difference Lane_{Diff2} can be determined between the master lane and the second lane L2 as a difference between the PI control word PPM_{PI-M} associated with the master lane and the PI control word PPM_{PI-2} associated with the second lane L2, a third lane difference Lane_{Diff3} can be determined between the master lane and the third lane L3 as a difference between the PI control word PPM_{PI-M} associated with the master lane and the PI control word PPM_{PI-3} associated with the third lane L3, a fourth lane difference Lane_{Diff4} can be determined between the master lane and the fourth lane L4 as a difference between the PI control word PPM_{PI-M} associated with the master lane and the PI control word PPM_{PI-4} associated with the fourth lane L4, a fifth lane difference Lane_{Diff5} can be determined between the master lane and the fifth lane L5 as a difference between the PI control word PPM_{PI-M} associated with the master lane and the PI control word PPM_{PI-5} associated with the fifth lane L5, a sixth lane difference Lane_{Diff6} can be determined between the master lane and the sixth lane L6 as a difference between the PI control word PPM_{PI-M} associated with the master lane and the PI control word PPM_{PI-6} associated with the second lane L6, and a seventh lane difference Lane_{Diff7} can be determined between the master lane and the seventh lane L7 as a difference between the PI control word PPM_{PI-M} associated with the master lane and the PI control word PPM_{PI-7} associated with the seventh lane L7. These determined lane differences can be used to calculate differences at 210, e.g., as shown in FIG. 6.

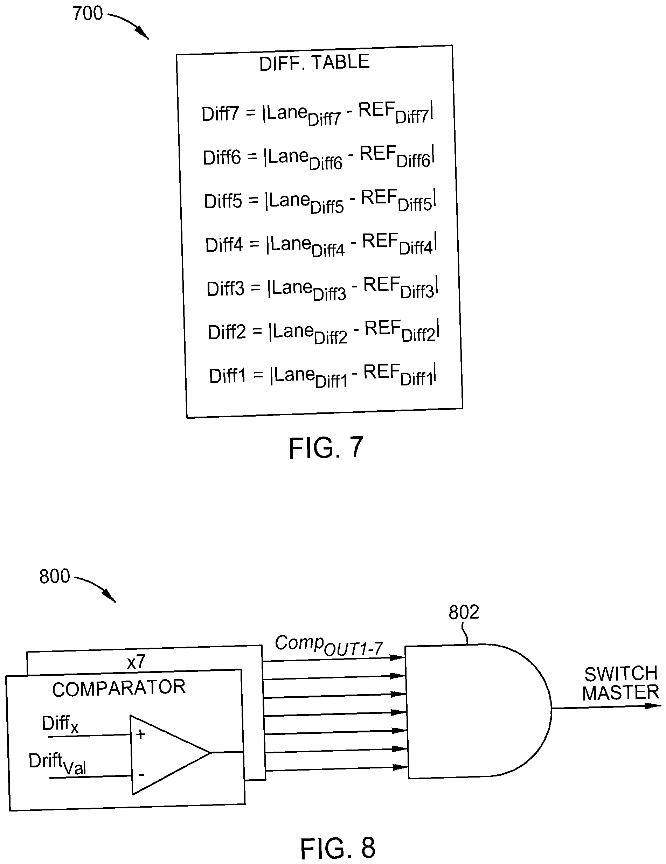

At 210, the method 200 can include calculating a difference Diffx associated with each one of the non-master lanes, wherein the difference Diffx associated with a given one of the non-master lanes is calculated as a difference between the lane difference LaneDiffx associated with the given one of the non-master lanes and a reference lane difference REF_{DIFF} associated with the given one of the non-master lanes. FIG. 7 shows a difference table 700 that includes a difference Diffx associated with each one of the non-master lanes.

For instance, as shown in FIG. 7, a first difference Diff1 can be calculated as an absolute value of a difference between the first lane difference Lane_{Diff1} associated with the first lane L1 and the first reference lane difference REF_{DIFF1} associated with the first lane L1. Also, a second difference Diff2 can be calculated as an absolute value of a difference between the second lane difference Lane_{Diff2} associated with the second lane L2 and the second reference lane difference REF_{DIFF2} associated with the second lane L2, a third difference Diff3 can be calculated as an absolute value of a difference between the third lane difference Lane_{Diff3} associated with the third lane L3 and the third reference lane difference REF_{DIFF3} associated with the third lane L3, a fourth difference Diff4 can be calculated as an absolute value of a difference between the fourth lane difference Lane_{Diff4} associated with the fourth lane L4 and the fourth reference lane difference REF_{DIFF4} associated with the fourth lane L4, a fifth difference Diff5 can be calculated as an absolute value of a difference between the fifth lane difference Lane_{Diff5} associated with the fifth lane L5 and the fifth reference lane difference REF_{DIFF5} associated with the fifth lane L5, a sixth difference Diff6 can be calculated as an absolute value of a difference between the sixth lane difference Lane_{Diff6} associated with the sixth lane L6 and the sixth reference lane difference REF_{DIFF6} associated with the sixth lane L6, and a seventh difference Diff7 can be calculated as an absolute value of a difference between the seventh lane difference Lane_{Diff7} associated with the seventh lane L7 and the seventh reference lane difference REF_{DIFF7} associated with the seventh lane L7. These differences, or "differences of the differences" can be used to detect whether the master lane or one or more non-master lanes has dropped.

At 212, the method 200 can include determining whether at least one of the differences Diffₓ has reached a drift threshold Drift_{Val}. For instance, in at least one implementation, each one of the differences calculated at 210 can be compared to the drift threshold Drift_{Val}. For instance, the detection system 138 (FIGS. 1A and 1B) can include a plurality of comparators 800 as depicted in FIG. 8 that can respectively compare the differences Diffₓ determined at 210 with the drift threshold Drift_{Val}. Each one of the comparators 800 can provide an output indicating whether its associated difference Diffₓ has reached the drift threshold Drift_{Val}. These outputs Comp_{OUT1-7} can be provided to a logic gate 802 for processing. The logic gate 802 can determine whether all, some, or none of the differences Diffₓ have reached the drift threshold Drift_{Val}. In at least one implementation, the drift threshold Drift_{Val} can be set as the same value for all of the comparators 800. In one or more other implementations, the drift threshold Drift_{Val} can be set as a different value for at least one of the comparators 800.

At 214, when all of the differences Diffₓ have reached the drift threshold Drift_{Val} as determined at 212, the method 200 can include determining that the master lane has dropped or is otherwise invalid. That is, when all of the differences Diffₓ are not less than the drift threshold Drift_{Val} as determined at 212 (i.e., all of the differences Diffₓ have exceeded the drift threshold Drift_{Val}), it can be determined that the master lane has dropped or is otherwise invalid. Thus, when all of the differences Diffₓ have reached the drift threshold Drift_{Val}, the master lane is detected as being dropped or invalid. Consequently, at 214, the method 200 can include performing a control action, including switching the master lane from one lane to another, resulting in a new master lane. For instance, continuing with the example in which the master lane is assigned to the zeroth lane L0, the master lane can be switched from the zeroth lane L0, e.g., to a neighbor lane, when the zeroth lane L0 drops as shown in FIG. 1A by the "X". As noted earlier, with reference to FIG. 1B, switching the master lane to another lane can change which lane's PI control word is routed to the transmitter clock generator 144 as well as the frequency error PPM_{E} (which corresponds to the frequency control word associated with the master lane) that is output by the firmware multiplexer 148, which can be used to ultimately determine the oscillator input TXOᵢₙ output from the firmware 142 to drive the tunable oscillator 156.

In at least one implementation, switching the master lane can include switching the master lane to a next valid lane of the plurality of lanes according to a predetermined sequence of priority. In at least one implementation, switching the master lane can include switching the master lane to a lane that has a smallest calculated difference Diffₓ.

At 216, when at least one of the differences Diffₓ has not reached the drift threshold Drift_{Val} as determined at 212, the method 200 can include determining that the master lane has not dropped, or rather, that the master lane is valid. That is, when at least one of the differences Diffₓ has not reached the drift threshold Drift_{Val} (i.e., at least one of the differences Diffₓ has not exceeded the drift threshold Drift_{Val}), it can be determined that the master lane has not dropped as there is at least one valid lane. Accordingly, at 216, the master lane can be kept, or stated differently, the lane that is currently assigned as the master lane can remain as the master lane.

Further, when none of the differences Diffₓ are less than the drift threshold Drift_{Val} as determined at 216, it can be determined that then none of the lanes have dropped. Stated another way, all lanes can be detected as being valid.

When one or more of the differences Diffₓ, but not all, are less than the drift threshold Drift_{Val} as determined at 216, then the lanes associated with the one or more differences Diffₓ that have reached the drift threshold Drift_{Val} can be detected as being dropped or otherwise invalid. For instance, in at least one example, when the fourth difference Diff4 associated with the fourth lane L4 is determined to have reached the drift threshold Drift_{Val} as determined at 212, and at least one of the other differences Diffₓ is less than the drift threshold Drift_{Val} (or at least one of the other differences Diffₓ has not reached the drift threshold Drift_{Val}), then the fourth lane L4 can be detected as being dropped or otherwise invalid. The validity of at least one other lane indicates that the master is valid, and as a result, it can be determined that the fourth lane L4 is indeed invalid as the fourth difference Diff4 has reached the drift threshold Drift_{Val}. It will be appreciated that more than one of the non-master lanes can be detected as being dropped or otherwise invalid in a given iteration of the method 200.

In at least one implementation at 216, the method 200 can include determining whether the difference Diffₓ associated with the neighbor lane has reached the drift threshold Drift_{Val}; detecting that the neighbor lane has dropped when the difference Diffₓ associated with the neighbor lane has reached the drift threshold Drift_{Val}; and performing a control action, including switching the neighbor lane from the one lane of the non-master lanes to another lane of the plurality of lanes, resulting in a new neighbor lane. For instance, in at least one example, the zeroth lane L0 can be assigned as the master lane and the fifth lane L5 can be assigned as the neighbor lane. In such examples, at 216, the method 200 can include determining whether the fifth difference Diff5 associated with the fifth lane L5 (the neighbor lane in this example) has reached the drift threshold Drift_{Val}. When the fifth difference Diff5 associated with the fifth lane L5 has reached the drift threshold Drift_{Val}, then the neighbor lane (the fifth lane L5 in this example) can be detected as being dropped or otherwise invalid. Accordingly, the neighbor lane can be switched from being assigned to the fifth lane L5 to another lane, such as the sixth lane L6.

In at least one example, in determining whether at least one of the differences Diffₓ has reached the drift threshold Drift_{Val}, the difference Diffₓ associated with the neighbor lane can be a first one of the differences Diffx that is compared with the drift threshold Drift_{Val}. In this regard, the validity of the master lane and the neighbor lane can be checked simultaneously.

At 218, the method 200 can include performing a control action, including updating a lane status flag of one or more of the lanes. In at least one example, when at least one, but not all, of the differences Diffₓ have reached the drift threshold Drift_{Val}, a lane status flag of each lane of the plurality of lanes determined to have its difference Diffₓ reach the drift threshold Drift_{Val} can be updated to indicate that the lane is invalid. In at least one example, when all lanes are found to be valid, the lane status flags of all lanes can be kept "as is" or the same as in the previous iteration of the method 200.

In at least one implementation, when the master lane is switched from one lane to another, the lane status flag of the former master lane can be updated to "invalid" and the lane status flag of the new master lane can be updated to "master". For instance, when the master lane is assigned to the zeroth lane L0 and then switched to the first lane L1 after finding that the zeroth lane L0 has dropped, the lane status flag of the zeroth lane L0 (i.e., the former master lane in this example) can be updated to "invalid" and the lane status flag of the first lane L1 (i.e., the new master lane in this example) can be updated to "master".

In at least one implementation, when the master lane is found to be valid but the neighbor lane (i.e., the lane assigned to be the next master lane should the master lane be found to be invalid) is found to have dropped or is otherwise invalid and thus has been switched to another one of the non-master lanes, the lane status flag of the former neighbor lane can be updated to "invalid" and the lane status flag of the new neighbor lane can be updated to "neighbor". For instance, when the master lane is assigned to the zeroth lane L0 and the first lane L1 is assigned as the neighbor lane, and then the first lane L1 is switched to the second lane L2 after finding that the first lane L1 has dropped, the lane status flag of the zeroth lane L0 can be kept as "master", the lane status flag of the first lane L1 (i.e., the former neighbor lane in this example) can be updated to "invalid", and the lane status flag of the second lane L2 (i.e., the new neighbor lane in this example) can be updated to "neighbor".

In at least one implementation, when the master lane and the neighbor lane are found to be valid but that one or more of the non-master lanes are found to have dropped or are otherwise invalid, the lane status flag of such lanes can be updated to "invalid".

At 220, the method 200 can include waiting a predetermined monitoring time. In at least one implementation, the predetermined monitoring time can be the time between time steps of the processing unit executing the firmware 142. In at least one implementation, the predetermined monitoring time can be a predetermined time interval, such as 500 microseconds, 1 millisecond, 1 second, etc.

At 222, the method 200 can include determining whether the status of any of the lanes has changed. For instance, when the master lane is switched from one lane to another, or when the neighbor lane is switched to another non-master lane, or when one or more of the non-master lanes are detected as being invalid, it can be determined at 222 that the lane status of at least one lane has changed.

When the lane status of all lanes has remained the same (or unchanged) as determined at 222, the method 200 can revert to 208 for a subsequent iteration. In the subsequent iteration of the method 200, a new lane difference table can be generated at 208 (using more recently captured PI control words), new differences can be calculated at 210 using the newly calculated lane differences from the new lane difference table, lane detection operations and status updates can occur at 212, 214, 216, 218, a predetermined waiting time can elapse at 220, and finally a lane change status check can occur once again at 222. The method 200 can iterate in further subsequent iterations.

When the lane status of at least one of the lanes has changed, the method 200 can revert to 204 for a subsequent iteration. In the subsequent iteration of the method 200, a new reference table can be generated at 204. For instance, reference lane differences REF_{DIFF} can be omitted for invalid lanes in the newly generated reference table. The method 200 can proceed to execute the remaining operations of the method 200 after executing 204 and 206 as set forth above.

In at least one example, the master lane can be switched from one lane to another (e.g., from the zeroth lane L0 to the first lane L1) at 214, and the lane status of these lanes can be updated accordingly at 218. For instance, at 218, the lane status of the zeroth lane L0 can be updated to "invalid" and the first lane L1 can be updated to "master" as it is the new master lane. As the lane status of these two lanes has changed as determined at 222, the method 200 can iterate, proceeding to 204 so that a new reference table can be generated. The new reference table can be generated as set forth above, except that now the reference lane differences REF_{DIFF} are determined with respect to the new master lane, which is the first lane L1 in this example. Stated another way, the reference lane differences REF_{DIFF} in the new reference table can be determined between the new master lane (i.e., the first lane L1 in this example) and a given one of the non-master lanes as a difference between the PI control word PPM_{PI} associated with the new master lane and the PI control word PPM_{PI} associated with the given one of the non-master lanes.

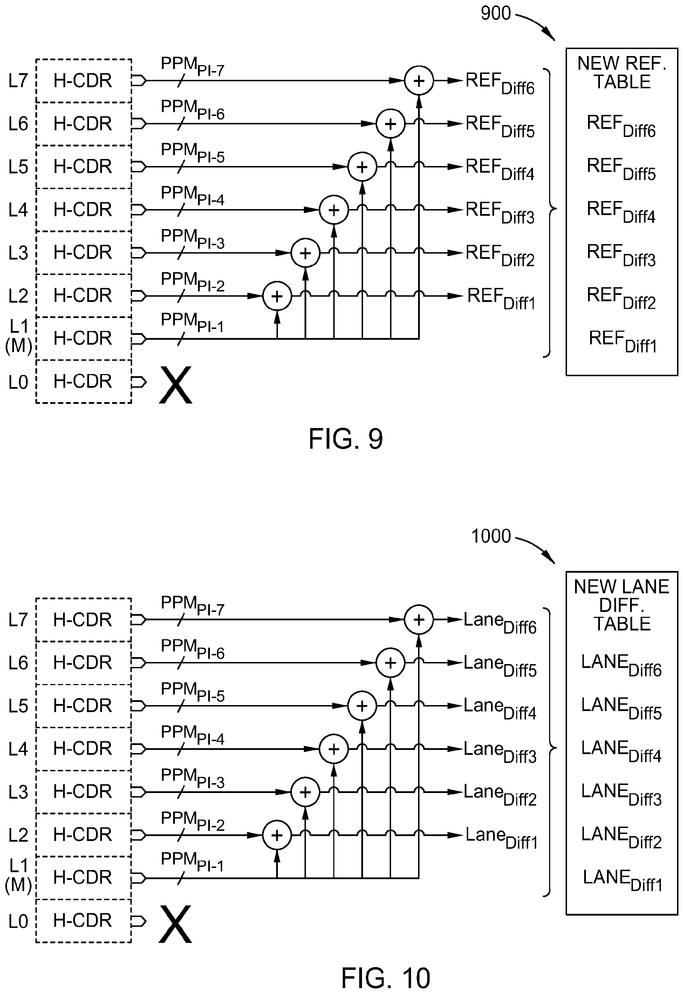

For instance, FIG. 9 shows the construction of a new reference table 900. As shown in FIG. 9, the reference lane differences REF_{DIFF} are determined with respect to the first lane L1, the new master. The first lane L1 has the "M" designation in FIG. 9, representing that the first lane L1 is the master lane in this subsequent iteration. The zeroth lane L0, which was determined to be invalid in the previous iteration of the method 200, can be removed from consideration in determining the new reference table 900. Thus, only six (6) reference lane differences REF_{DIFF} are determined for the new reference table 900, as there are only seven (7) valid lanes at this time. In at least one implementation, in constructing the new reference table 900, only the valid lanes need be considered.

Further, in performing the subsequent iteration of the method 200, at 206, a PI control word PPM_{PI} for each lane of the plurality of lanes can be captured, including for the new master lane (i.e., the first lane L1 in this example) and for other ones of the plurality of lanes, which are valid and designated as non-master lanes (i.e., lanes L2 - L7, and not including the zeroth lane L0 in this example). At 208, in the subsequent iteration, a new lane difference table 1000 can be generated, e.g., as shown in FIG. 10. The new lane difference table 1000 can include lane differences Lane_{DiffX} associated with each one of the non-master lanes. The new lane difference table 1000 can be generated by determining a lane difference Lane_{DiffX} between the new master lane (i.e., the first lane L1 in this example) and respective ones of the non-master lanes, with the lane difference Lane_{DiffX} being determined between the new master lane and a given one of the non-master lanes as a difference between the PI control word PPM_{PI} associated with the new master lane and the PI control word PPM_{PI} associated with the given one of the non-master lanes. As shown in FIG. 10, the lane differences Lane_{DiffX} are determined with respect to the first lane L1, the new master.

Then, at 210, in the subsequent iteration, a difference Diffₓ associated with each one of the non-master lanes is calculated. The difference Diffₓ associated with a given one of the non-master lanes is calculated as a difference between the lane difference LaneDiffx associated with the given one of the non-master lanes, with the lane difference Lane_{Diffx} being accessed from the new lane difference table 1000 and associated with the given one of the non-master lanes, and a reference lane difference REF_{DIFF}, which is accessed from the new reference table 900 and associated with the given one of the non-master lanes. For instance, a new first difference Diff1 can be calculated as an absolute value of a difference between the first lane difference Lane_{Diff1} (accessed from the new lane difference table 1000) associated with the second lane L2 and the first reference lane difference REF_{DIFF1} (accessed from the new reference table 900) associated with the second lane L2. The other differences for the other non-master lanes can be calculated as well.

In the subsequent operation, at 212, it can be determined whether at least one of the newly calculated differences Diffₓ has reached the drift threshold Drift_{Val}, and operations 214 or 216, 218, 220, and 222 can follow as previously described based on the determinations at 212 for the subsequent iteration. Subsequent iterations of the method 200 can be executed. In one more implementations, the method 200 can be revert or reset to 202, e.g. periodically, upon power up, etc.

Accordingly, the validity of the master lane can be continuously or periodically monitored, along with the non-master lanes, and the master lane can be switched to another lane when the master land drops or otherwise becomes invalid. To summarize, the differences between the PI control words for the non-master lanes and the PI control word for the master lane can be determined, and differences between these determined differences and reference differences can be calculated and compared to a threshold. Hence, the "difference-of-the-difference" designation of this technique. When all of the calculated differences have reached the threshold, the master lane can be detected as invalid, and the master lane can be switched to another valid lane, such as a valid neighbor lane. The fast switching of the master lane to a valid lane can increase the performance of an optical transceiver, for example. When one or some, but not all, of the calculated differences have reached the threshold, the non-master lanes associated with these calculated differences can be detected as invalid, e.g., and removed from further consideration for one or more subsequent iterations.

In one or more alternative examples of the method 200, a single lane difference can be determined at 208 (e.g., between the master lane and a neighbor lane), and this single lane difference can be used to calculate a single difference at 210. The single difference can then be checked against the drift threshold at 212. When the single difference has not reached the threshold (or is less than the drift threshold), the master lane can be determined as valid, the lane status can be updated at 218, and the method can proceed 200 as described herein. When the single difference has reached the threshold (or is greater than the drift threshold) as determined at 212, the master lane is possibly invalid. Consequently, the method can proceed with a further investigation. Specifically, in one example, lane differences between the master lane and all other non-master lanes can be determined (the lane difference between the master and the neighbor lane has already been determined above). These lane differences can be used along with respective reference lane differences to determine the differences (or error values). When all the differences have reached the drift threshold, then it can be confirmed that the master lane is indeed invalid. Control actions can be taken accordingly, such as switching of the master lane, updating the lane status flags, etc. When not all of the differences have reached the drift threshold, then it can be determined that the master lane is valid and that the neighbor lane is invalid. Control actions can be taken accordingly, such as switching of the neighbor lane, updating the lane status flags, etc. Such alternative examples of the method 200 can advantageously reduce the number of computations per iteration, which can save computing resources for other tasks, among other benefits.

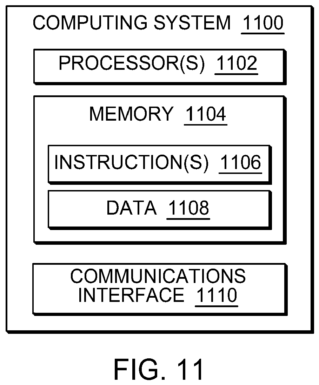

FIG. 11 is a block diagram of the computing system 1100 that can be implemented with the optical module 100 and/or multi-lane optical transceiver 120 (FIGS. 1A and 1B) disclosed herein.

As shown in FIG. 11, the computing system 1100 can include one or more processor(s) 1102 and one or more memory device(s) 1104. The one or more processor(s) 1102 can include any suitable processing device, such as a microprocessor, microcontroller, integrated circuit, logic device, or other suitable processing device. The one or more memory device(s) 1104 can include one or more computer-readable medium, including, but not limited to, non-transitory computer-readable medium, RAM, ROM, hard drives, flash drives, and other memory devices.

The one or more memory device(s) 1104 can store information accessible by the one or more processor(s) 1102, including computer-readable instructions 1106 or computer-readable program code that can be executed by the one or more processor(s) 1102. The instructions 1106 can be any set of instructions or program that, when executed by the one or more processor(s) 1102, cause the one or more processor(s) 1102 to perform operations. The instructions 1106 can be software written in any suitable programming language or can be implemented in hardware as firmware. In at least one example, the instructions 1106 can include the detection system 138 (FIGS. 1A and 1B).

The memory device(s) 1104 can further store data 1108 that can be accessed by the processor(s) 1102. For example, the data 1108 can include any of the data noted herein. The data 1108 can include one or more table(s), function(s), algorithm(s), model(s), equation(s), libraries, etc.

The computing system 1100 can also include a communication interface 1110 used to communicate, for example, with the other components of the optical module 100 (FIG. 1A). The communication interface 1110 can include any suitable components for interfacing with one or more network(s), including for example, transmitters, receivers, ports, controllers, antennas, or other suitable components.

In the current disclosure, reference is made to various embodiments. However, the scope of the present disclosure is not limited to specific described embodiments. Instead, any combination of the described features and elements, whether related to different embodiments or not, is contemplated to implement and practice contemplated embodiments. Additionally, when elements of the embodiments are described in the form of "at least one of A and B," or "at least one of A or B," it will be understood that embodiments including element A exclusively, including element B exclusively, and including element A and B are each contemplated. Furthermore, although some embodiments disclosed herein may achieve advantages over other possible solutions or over the prior art, whether or not a particular advantage is achieved by a given embodiment is not limiting of the scope of the present disclosure. Thus, the aspects, features, embodiments and advantages disclosed herein are merely illustrative and are not considered elements or limitations of the appended claims except where explicitly recited in a claim(s).

As will be appreciated by one skilled in the art, the embodiments disclosed herein may be embodied as a system, method or computer program product. Accordingly, embodiments may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, embodiments may take the form of a computer program product embodied in one or more computer readable medium(s) having computer readable program code embodied thereon. In one example, there is provided a computer readable medium carrying instructions which, when executed by one or more processors, cause any of the methods described herein to be carried out.

Program code embodied on a computer readable medium may be transmitted using any appropriate medium, including but not limited to wireless, wireline, optical fiber cable, RF, etc., or any suitable combination of the foregoing.

Computer program code for carrying out operations for embodiments of the present disclosure may be written in any combination of one or more programming languages, including an object oriented programming language such as Java, Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present disclosure are described herein with reference to flowchart illustrations and/or block diagrams of methods, apparatuses (systems), and computer program products according to embodiments presented in this disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the block(s) of the flowchart illustrations and/or block diagrams.

These computer program instructions may also be stored in a computer readable medium that can direct a computer, other programmable data processing apparatus, or other device to function in a particular manner, such that the instructions stored in the computer readable medium produce an article of manufacture including instructions which implement the function/act specified in the block(s) of the flowchart illustrations and/or block diagrams.

The computer program instructions may also be loaded onto a computer, other programmable data processing apparatus, or other device to cause a series of operational steps to be performed on the computer, other programmable apparatus or other device to produce a computer implemented process such that the instructions which execute on the computer, other programmable data processing apparatus, or other device provide processes for implementing the functions/acts specified in the block(s) of the flowchart illustrations and/or block diagrams.

The flowchart illustrations and block diagrams in the Figures illustrate the architecture, functionality, and operation of possible implementations of systems, methods, and computer program products according to various embodiments. In this regard, each block in the flowchart illustrations or block diagrams may represent a module, segment, or portion of code, which comprises one or more executable instructions for implementing the specified logical function(s). It should also be noted that, in some alternative implementations, the functions noted in the block may occur out of the order noted in the Figures. For example, two blocks shown in succession may, in fact, be executed substantially concurrently, or the blocks may sometimes be executed in the reverse order, depending upon the functionality involved. It will also be noted that each block of the block diagrams and/or flowchart illustrations, and combinations of blocks in the block diagrams and/or flowchart illustrations, can be implemented by special purpose hardware-based systems that perform the specified functions or acts, or combinations of special purpose hardware and computer instructions.

In view of the foregoing, the scope of the present disclosure is determined by the claims that follow.

## Claims

1. A method, comprising:
capturing a phase interpolator (PI) control word for each lane of a plurality of lanes of an optical transceiver, wherein one lane of the plurality of lanes is assigned as a master lane and other ones of the plurality of lanes that are not the master lane are designated as non-master lanes;
determining a lane difference between the master lane and each of the non-master lanes, with the lane difference being determined between the master lane and a given one of the non-master lanes as a difference between the **PI** control word associated with the master lane and the **PI** control word associated with the given one of the non-master lanes;
calculating a difference associated with each one of the non-master lanes by determining a difference between the lane difference associated with a given one of the non-master lanes and a reference lane difference associated with the given one of the non-master lanes;
upon determining that at least one of the differences has reached a drift threshold, determining that the master lane or one or more of the non-master lanes is invalid based on which of the differences have reached the drift threshold; and
performing a control action when the master lane or one or more of the non-master lanes is invalid.

2. The method of claim 1, wherein, when all of the differences have been determined to have reached the drift threshold, the master lane is determined as invalid.

3. The method of claim 2, wherein, when the master lane is determined as being invalid, performing the control action comprises switching the master lane from the one lane to another lane of the plurality of lanes, resulting in a new master lane.

4. The method of claim 3, wherein switching the master lane comprises switching the master lane to a next valid lane of the plurality of lanes according to a predetermined sequence of priority.

5. The method of claim 3 or claim 4, wherein switching the master lane comprises switching the master lane to a lane of the plurality of lanes that has a smallest calculated difference.

6. The method of any of claims 3 to 5, wherein the control action further comprises:
updating a lane status flag of the one lane to indicate that the one lane is invalid; and
updating a lane status flag of the other lane, which has been switched to the new master lane, to indicate that the other lane is the new master lane.

7. The method of any of claims 3 to 6, wherein the reference lane differences are accessed from a reference table, and wherein the method further comprises:
generating a new reference table, wherein new reference lane differences in the new reference table are determined between the new master lane and a given one of the non-master lanes as a difference between a newly captured PI control word associated with the new master lane and a newly captured PI control word associated with the given one of the non-master lanes,
optionally wherein the method further comprises:
performing a subsequent iteration of the method, comprising:
capturing, in the subsequent iteration, a PI control word for each lane of the plurality of lanes, including for the new master lane and for other ones of the plurality of lanes, which are valid and designated as non-master lanes;
determining, in the subsequent iteration, a lane difference between the new master lane and each of the non-master lanes, with the lane difference being determined between the new master lane and a given one of the non-master lanes as a difference between the PI control word associated with the new master lane and the PI control word associated with the given one of the non-master lanes;
calculating, in the subsequent iteration, a difference associated with each one of the non-master lanes by determining a difference between the lane difference associated with a given one of the non-master lanes and a new reference lane difference, which is accessed from the new reference table and associated with the given one of the non-master lanes;
upon determining, in the subsequent iteration, that at least one of the differences has reached the drift threshold, determining that the new master lane or one or more of the non-master lanes is invalid based on which of the differences have reached the drift threshold; and
performing a control action when the new master lane or one or more of the non-master lanes is invalid.

8. The method of any preceding claim, wherein, when one or more, but not all, of the differences have reached the drift threshold, the master lane is determined as being valid,
optionally wherein one lane of the non-master lanes is assigned as a neighbor lane, and wherein the method further comprises:
upon determining that the difference associated with the neighbor lane has reached the drift threshold, determining that the neighbor lane is invalid, and wherein performing the control action further comprises:
updating a lane status flag of the neighbor lane to indicate that the neighbor lane is invalid; and
switching the neighbor lane from the one lane of the non-master lanes to another lane of the plurality of lanes, resulting in a new neighbor lane,
further optionally wherein, in determining that at least one of the differences has reached the drift threshold, the difference associated with the neighbor lane is a first one of the differences that is compared with the drift threshold.

9. The method of claim 8, wherein performing the control action comprises:
updating a lane status flag of each lane of the plurality of lanes determined to have its difference reach the drift threshold to indicate that the lane is invalid.

10. The method of any preceding claim, further comprising:
generating, prior to capturing the PI control word for each lane of the plurality of lanes, a reference table during a reference capture period by:
capturing, during the reference capture period, a PI control word of each lane of the plurality of lanes;
determining, during the reference capture period, the reference lane difference associated with each one of the non-master lanes, with the reference lane difference being determined for a given one of the non-master lanes as a difference between the PI control word associated with the master lane and the PI control word associated with the given one of the non-master lanes; and
constructing, during the reference capture period, the reference table to include the reference lane difference, and
wherein the reference lane differences from the reference table are used in determining the differences associated with each one of the non-master lanes.

11. The method of any preceding claim, wherein the reference lane differences are accessed from a reference table, and wherein, when none of the differences have reached the drift threshold, the reference table is not updated for a subsequent iteration of the method.

12. An optical transceiver, comprising:
a plurality receivers each having a clock and data recovery (CDR) circuit;
a plurality of optical drivers electrically coupled with the receivers via respective ones of a plurality of lanes; and
a processor arranged to execute a program to perform operations, the operations comprising:
capturing, from the CDR circuits, a phase interpolator (PI) control word for each lane of a plurality of lanes, wherein one lane of the plurality of lanes is assigned as a master lane and other ones of the plurality of lanes that are not the master lane are designated as non-master lanes;
determining a lane difference between the master lane and each of the non-master lanes, with the lane difference being determined between the master lane and a given one of the non-master lanes as a difference between the PI control word associated with the master lane and the PI control word associated with the given one of the non-master lanes;
calculating a difference associated with each one of the non-master lanes by determining a difference between the lane difference associated with a given one of the non-master lanes and a reference lane difference associated with the given one of the non-master lanes;
upon determining that at least one of the differences has reached a drift threshold, determining that the master lane or one or more of the non-master lanes is invalid based on which of the differences have reached the drift threshold; and
performing a control action when the master lane or one or more of the non-master lanes is invalid.

13. The optical transceiver of claim 12, wherein the operations comprise the method of any of claims 2 to 11.

14. An optical module, comprising:
an application-specific integrated circuit (ASIC);
an optical transceiver electrically coupled with the ASIC by a plurality of lanes, and wherein the optical transceiver has a transmitter phase-locked loop (PLL) arranged to receive a phase interpolator (PI) control word from a master lane of the plurality of lanes; and
a processor arranged to execute a program to perform operations, the operations comprising:
capturing a PI control word for each lane of the plurality of lanes, wherein one lane of the plurality of lanes is assigned as the master lane and other ones of the plurality of lanes that are not the master lane are designated as non-master lanes;
determining a lane difference between the master lane and each of the non-master lanes, with the lane difference being determined between the master lane and a given one of the non-master lanes as a difference between the PI control word associated with the master lane and the PI control word associated with the given one of the non-master lanes;
calculating a difference associated with each one of the non-master lanes by determining a difference between the lane difference associated with a given one of the non-master lanes and a reference lane difference associated with the given one of the non-master lanes;
upon determining that each one the differences has reached a drift threshold, determining that the master lane is invalid; and
switching the master lane from the one lane to another lane of the plurality of lanes so that the transmitter PLL receives the PI control word from the other lane that is now the master lane.

15. One or more computer readable media comprising instructions that, when executed by one or more processors, cause the method of any of claims 1 to 11 to be carried out.
